# EUROPEAN PATENT APPLICATION

(11) **EP 2 086 049 A1**
(43) Date of publication of application: **05.08.2009**
(21) Application number: 09250147.7
(22) Date of filing: 20.01.2009
(51) Int. Cl.: H01Q 1/24, H01Q 1/40

(54) **Housing, wireless communication device using the housing, and manufacturing method thereof**

(30) Priority: 30.01.2008 CN 200810300265
(71) Applicant: Shenzhen Futaihong Precision Industry Co., Ltd., Shenzhen City, Guangdong Province 518109 (CN); FIH (Hong Kong) Limited, Hong Kong (HK)
(72) Inventor: Yang, Fu-Keng, Shindian City, Taipei Hsien Taiwan 231 (CN); Zhang, Bing, ShenZhen City, Guangdong Province 518109 (CN); Zeng, Yi-Ping, ShenZhen City, Guangdong Province 518109 (CN); Zhan, Jian-Jun, ShenZhen City, Guangdong Province 518109 (CN)
(74) Representative: Craven, Ian

(57) **Abstract**

A housing for a wireless communication device includes a decorative film (131), an antenna pattern (132) formed on the decorative film, and a substrate (134) moldingly attached to the decorative film and the antenna pattern. The antenna is made of a metal coating. The antenna pattern is sandwiched between the decorative film and the substrate.

## Description

The present disclosure relates to wireless communication devices, and particularly to a device housing having a conductive track for sending and receiving electromagnetic waves.

Antennas sending or receiving electromagnetic waves are basic units used in mobile communication devices. With increasing demand for reduced device profile, antennas are frequently incorporated into housings of such devices.

The antennas incorporated in the housings are usually copper or silver sheets formed in a patterned conductive track. A frequent method of be thinner such housings includes attaching a patterned copper or silver sheet to a laminate using adhesive, in which the laminate may be a plastic film used in an insert molding process. The laminate is mounted into an injection mold, and a melted resin is injected into the injection mold and molded thereon to form a molded housing. The resulting patterned copper or silver sheet can function as an antenna when the molded housing is used in a mobile communication device. However, the patterned copper or silver sheet typically has a thickness exceeding 0.3 millimeters (mm), increasing the thickness and size of the molded housing.

Therefore, there is room for improvement within the art.

### BRIEF DESCRIPTION OF THE DRAWINGS

Many aspects of the housing for a wireless communication device can be better understood with reference to the following drawings. The components in the drawings are not necessarily drawn to scale, the emphasis instead being placed upon clearly illustrating the principles of the molded article. Moreover, in the drawings like reference numerals designate corresponding parts throughout the several views.

FIG. 1 is a schematic view of a wireless communication device.

FIG. 2 is an exploded view of the wireless communication device of FIG. 1.

### DETAILED DESCRIPTION OF THE DISCLOSURE

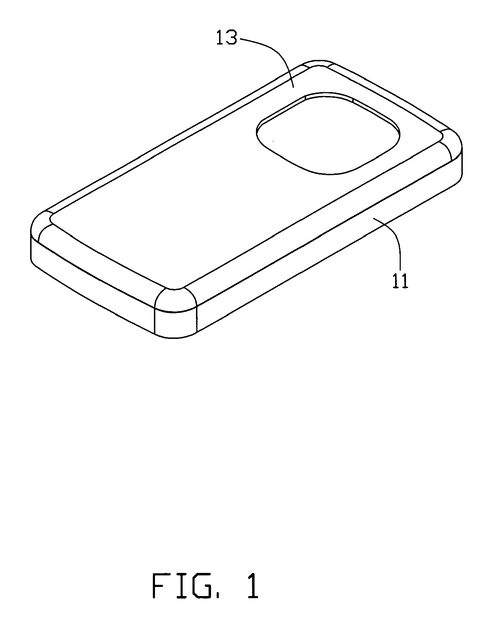

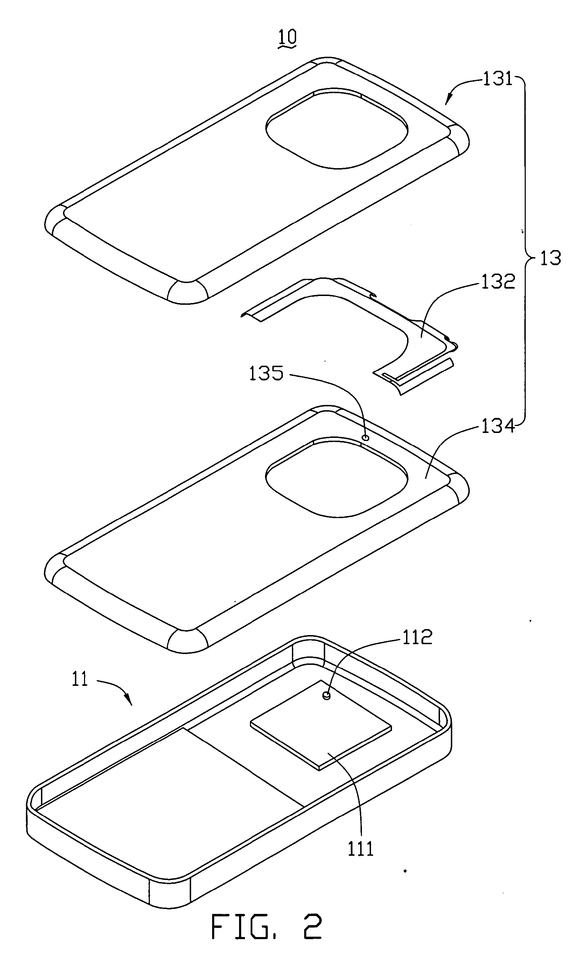

Referring to FIG. 1 and FIG. 2, the disclosed wireless communication device 10, here a mobile phone, includes a main body 11 and the disclosed housing 13 mounted on the main body 11.

The main body 11 includes a printed circuit board 111 installed therein. The printed circuit board 111 has a flexible conductive pole 112 configured for sending and/or receiving electromagnetic waves.

The housing 13 includes a decorative film 131, an antenna pattern 132 formed on the decorative film 131, and a substrate 134 moldingly attached to the decorative film 131 and/or the antenna pattern 132 as the antenna pattern 132 does not cover the entirety of the decorative film 131. The antenna pattern 132 is accordingly sandwiched between the decorative film 131 and the substrate 134.

The decorative film 131 may be plastic, such as polycarbonate, acrylonitrile-butadiene-styrene, polyethylene, polyethylene terephthalate, or polypropylene. The decorative film 131 may have graphics, for example, logo of the manufacturer, formed thereon.

The antenna pattern 132 is a metal coating of copper or silver. The antenna pattern 132 is manufactured via physical vacuum deposition. The antenna pattern 132 is from 0.002mm to 0.01 5mm thick.

The substrate 134 is a molded part formed by injecting a moldable material such as plastic or silicone onto the decorative film 131 with the antenna pattern 132 formed thereon during an injection molding process. The substrate 134 is moldable material such as polycarbonate, acrylonitrile-butadiene-styrene, polyethylene, polyethylene terephthalate, or poly propylene, polymethyl methacrylate, silicone or any combination thereof. The substrate 134 may have a through hole 135 defined therein, the same size as the flexible conductive pole 112.

When the housing 13 is mounted on the main body 11, the flexible conductive pole 112 of the printed circuit board 111 enters the through hole 135 of the substrate 134 in such a manner that the conductive pole 112 contacts with or is close to the antenna pattern 132. When close to the antenna pattern 132, the gap between the conductive pole 112 and the antenna pattern 132 is less than 0.5mm. As such, the antenna pattern 132 can communicate with the printed circuit board 111 of the main body 11.

Understandably, the flexible conductive pole 112 can be alternatively installed on the antenna pattern 132, with the gap between the conductive pole 112 and the printed circuit board 111 less than 0.5mm.

During manufacture of the housing 13as disclosed, the decorative film 131 is provided and then coated with metal coating of copper or silver to form the antenna pattern 132 via vacuum deposition. The decorative film 131 with the antenna pattern 132 formed thereon is placed into an injection mold. Molten moldable material is injected onto the antenna pattern 132 and the decorative film 131, forming the substrate 134. The desired housing 13 with an antenna integrated thereon is thus obtained.

The antenna pattern 132 obtained by the disclosed process may be thinner than a currently used metal sheet antenna, thereby benefiting the reduction in profile and size of the wireless communication device 10, and provides a simplified be thinner process as well.

It should be also understood, however, that even though numerous characteristics and advantages of the present embodiments have been set forth in the foregoing description, together with details of the structures and functions of the embodiments, the disclosure is illustrative only, and changes may be made in detail, especially in matters of shape, size, and arrangement of parts within the principles of the disclosure to the full extent indicated by the broad general meaning of the terms in which the appended claims are expressed.

## Claims

1. A housing for a wireless communication device, comprising:
a decorative film;
an antenna pattern disposed on the decorative film, the antenna comprising a metal coating; and
a substrate attached to the decorative film and the antenna pattern;
wherein the antenna pattern is sandwiched between the decorative film and the substrate.

2. The housing as claimed in claim 1, wherein the decorative film comprises polycarbonate, acrylonitrile-butadiene-styrene, polyethylene, polyethylene terephthalate, or poly propylene.

3. The housing as claimed in claim 1, wherein the antenna pattern is formed on the decorative film via physical vacuum deposition.

4. The housing as claimed in claim 1, wherein the antenna pattern is from 0.002mm to 0.01 5mm thick.

5. The housing as claimed in claim 1, wherein the substrate is moldable material of polycarbonate, acrylonitrile butadiene styrene, polyethylene, polyethylene terephthalate, poly propylene, polymethyl methacrylate, or silicone.

6. A wireless communication device, comprising:
a main body comprising a printed circuit board mounted therein, the printed circuit board comprising a conductive pole mounted thereon configured for sending and/or receiving electromagnetic waves; and
a housing mounted on the main body, comprising:
a decorative film;
an antenna pattern disposed on the decorative film, the antenna comprising a metal coating; and
a substrate attached to the decorative film and an antenna circuit patter, the antenna pattern sandwiched between the decorative film and the substrate.

7. The wireless communication device as claimed in claim 6, wherein the substrate is moldable material of polycarbonate, acrylonitrile butadiene styrene, polyethylene, polyethylene terephthalate, poly propylene, poly methyl methacrylate, or silicone.

8. The wireless communication device as claimed in claim 6, wherein the gap between the conductive pole and the antenna pattern is less than 0.5mm.

9. The wireless communication device as claimed in claim 6, wherein the flexible conductive pole of the printed circuit board is received in the through hole of the substrate and in contact with the antenna pattern.

10. The wireless communication device as claimed in claim 6, wherein the antenna pattern is from 0.002mm to 0.01 5mm thick.

11. A method for manufacturing a housing for a wireless communication device, comprising:
providing a decorative film;
attaching a metal coating onto the decorative film by physical vacuum deposition to form an antenna pattern; and
forming a substrate attached to the decorative film via injection molding.

12. The method for manufacturing a housing as claimed in claim 11, wherein the decorative film is polycarbonate, acrylonitrile-butadiene-styrene, polyethylene, polyethylene terephthalate, or poly propylene.

13. The method for manufacturing a housing as claimed in claim 11, wherein the antenna pattern from 0.002mm to 0.01 5mm.
